# EUROPEAN PATENT APPLICATION

(11) **EP 4 549 893 A1**
(43) Date of publication of application: **07.05.2025**
(21) Application number: 23923209.3
(22) Date of filing: 27.11.2023
(51) Int. Cl.: G01J 1/42, G01J 1/02, G01J 1/04, G01J 1/06

(54) **OPTICAL SENSOR PACKAGE STRUCTURE FOR ENABLING SENSING THROUGH LIGHT RECEPTION OF ULTRAVIOLET WAVELENGTH BAND AND CONVERTING ULTRAVIOLET SIGNAL INTO DIGITAL SIGNAL, AND MANUFACTURING METHOD THEREFOR**

(30) Priority: 21.09.2023 KR 20230126518
(71) Applicant: Allix Co., Ltd., Jeonju-si, Jeollabuk-do 54853 (KR)
(72) Inventor: HONG, Seok Yong, Jeonju-si Jeollabuk-do 55132 (KR); PARK, Jeong Hwan, Jeonju-si Jeollabuk-do 54853 (KR); PARK, Eun Mi, Jeonju-si Jeollabuk-do 54982 (KR)
(74) Representative: Cabinet Chaillot
(86) International application number: PCT/KR2023/019216
(87) International publication number: WO 2025/063385

(57) **Abstract**

The present disclosure relates to a package structure for an optical sensor that enables sensing through reception of light in an ultraviolet (UV) wavelength range and converts an UV signal to a digital signal and a method for manufacturing the same, and the package structure for the optical sensor that enables sensing through reception of light in the UV wavelength range and converts the UV signal to the digital signal includes a light shield disposed at a printed circuit board (PCB) substrate on which a device portion for light sensing is mounted, surrounding the device portion such that a light receiving part of the device portion is exposed, and made of a material that blocks visible light coming in from a side of the device portion except the light receiving part; and a light diffuser disposed at the light receiving part of the device portion, configured to allow the light to pass through and diffuse the light, and made of a material including silicon dioxide.

## Description

### [Technical Field]

The present disclosure relates to a package structure for an optical sensor that enables sensing through reception of light in an ultraviolet (UV) wavelength range and converts an UV signal to a digital signal and a method for manufacturing the same, and more particularly, to a package structure for an optical sensor that enables sensing through reception of light in an UV wavelength range and converts an UV signal to a digital signal, with an improved structure to reduce a measurement deviation with the incident angle of UV light incident on the optical sensor and minimize a change in sensing sensitivity with a change in incident angle and a method for manufacturing the same.

### [Background Art]

A chip on board (COB) type optical sensor in which an optical sensor chip is mounted on an upper surface of a printed circuit board generally has an electrode pad on a lower surface for electrical connection to a main board, and the printed circuit on the upper surface and the electrode pad on the lower surface are electrically connected through a through-hole. The electrical connection through the through-hole is made by the hole passing through the printed circuit on the upper surface and the electrode pad on the lower surface, and the inside of the hole is plated to electrically connect the printed circuit on the upper surface to the electrode pad on the lower surface.

The optical sensor is formed together with a package to block outside light and ensure reliability of semiconductor characteristics. The conventional optical sensor experiences a measurement deviation with the incident angle of light, has a change in sensing sensitivity with a change in incident angle and a reduction in absolute intensity of light incident on the optical sensor with increasing reflectance on the lens surface of the optical sensor, and suffers from noise caused by ambient light and outside moisture.

There is Patent Publication No. 10-2016-0073451 an example of prior art.

### [Disclosure]

### [Technical Problem]

The present disclosure is designed to solve the above-described problem, and therefore the present disclosure is directed to providing a package structure for an optical sensor that enables sensing through reception of light in an ultraviolet (UV) wavelength range and converts a UV signal to a digital signal to reduce a measurement deviation with the incident angle of UV light incident on the optical sensor, minimize a change in sensing sensitivity with a change in incident angle, prevent a reduction in absolute intensity of light incident on the optical sensor, and block ambient light and moisture coming in from outside and a method for manufacturing the same.

The problems to be solved by the present disclosure are not limited to the above-mentioned problems and these and other problems will be clearly understood by those skilled in the art from the following description.

### [Technical Solution]

To achieve the above-described objective, a package structure for an optical sensor that enables sensing through reception of light in an ultraviolet (UV) wavelength range and converts an UV signal to a digital signal according to the present disclosure includes a light shield disposed at a printed circuit board (PCB) substrate on which a device portion for light sensing is mounted, surrounding the device portion such that a light receiving part of the device portion is exposed, and made of a material that blocks visible light coming in from a side of the device portion except the light receiving part; and a light diffuser disposed at the light receiving part of the device portion, configured to allow the light to pass through and diffuse the light, and made of a material including silicon dioxide (SiO₂).

Preferably, the present disclosure further includes a filter unit including a filter portion stacked on the light diffuser and made of a material that allows light of a specific wavelength to pass through, and a pad portion disposed at the filter portion and located facing the light receiving part of the device portion to relatively reduce an intensity of direct light incident on the light receiving part.

The pad portion of the filter unit may face a central area of the light receiving part, and be formed with a narrower area than an area of the light receiving part, and be made of a light shielding material.

Preferably, the present disclosure further includes a package dam portion disposed between the filter portion of the filter unit and the PCB substrate, and surrounding a side of the light shield and the light diffuser to block light coming in from the side of the light diffuser.

Furthermore, a method for manufacturing a package structure for an optical sensor that enables sensing through reception of light in an UV wavelength range and converts an UV signal to a digital signal according to the present disclosure includes a dam forming step of forming, by a mold unit, a package dam portion at an edge of a PCB substrate on which a device portion for light sensing is mounted by a mold process, to form a placement space having an open side to place the device portion on the PCB substrate; a light shield forming step of mounting a mask unit on the package dam portion such that the mask unit covers the placement space, and feeding a light shielding material into the placement space through an inlet slit formed in the mask unit to form a light shield surrounding a side of the device portion; a coating step of separating the mask unit from the package dam portion, and feeding a light permeable material into the placement space to stack a light diffuser on the light receiving part of the device portion; and a filter mounting step of installing a filter unit at the package dam portion such that a filter portion is stacked on the light diffuser, to allow light of a specific wavelength to pass through and reduce an intensity of direct light incident on the light receiving part.

### [Advantageous Effects]

The above-described package structure for the optical sensor that enables sensing through reception of light in an ultraviolet (UV) wavelength range and converts an UV signal to a digital signal according to the present disclosure and the method for manufacturing the same includes the light shield surrounding the side of the device portion mounted on the printed circuit board (PCB) substrate to prevent light and moisture infiltration from the side of the device portion, and the light diffuser disposed at the light receiving part of the device portion and made of a material that allows UV light pass through to cause UV light incident on the light receiving part to penetrate and diffuse, thereby reducing the measurement deviation with the incident angle of UV light incident on the optical sensor, minimizing a change in sensing sensitivity with a change in incident angle, preventing a reduction in absolute intensity of light incident on the optical sensor, and blocking ambient light and moisture coming in from outside.

The effects of the present disclosure are not limited to the above-mentioned effects and these and other effects will be clearly understood by those skilled in the art from the following description.

### [Description of Drawings]

FIG. 1 is a cross-sectional view illustrating a package structure for an optical sensor that enables sensing through reception of light in an ultraviolet (UV) wavelength range and converts an UV signal to a digital signal according to an embodiment of the present disclosure.
FIG. 2 is a top view of an embodiment of the present disclosure.
FIG. 3 is a block diagram illustrating a method for manufacturing a package structure for an optical sensor that enables sensing through reception of light in an UV wavelength range and converts an UV signal to a digital signal according to an embodiment of the present disclosure.
FIG. 4 is a conceptual view illustrating a manufacturing method of an embodiment of the present disclosure.
FIGS. 5 and 6 are diagrams illustrating a mask unit for forming a light shield in a manufacturing method of an embodiment of the present disclosure.
FIG. 7 is a diagram illustrating an extension rib employed in a mask unit used to form a light shield in a manufacturing method of an embodiment of the present disclosure.

### [Best Mode]

In the following description, for a clear understanding of the present disclosure, descriptions of known technology associated with the features of the present disclosure are omitted. The following embodiment provides a detailed description for helping the understanding of the present disclosure, and it is apparent that this is not intended to limit the scope of protection of the present disclosure. Accordingly, the equivalent invention that carries out the same function as the present disclosure will fall within the scope of protection of the present disclosure.

Furthermore, in the following description, the same reference sign indicates the same element, and unnecessary overlapping descriptions and descriptions of known technology are omitted. Additionally, the following description of each embodiment of the present disclosure that overlaps the description of the background art is omitted.

Hereinafter, a package structure for an optical sensor that enables sensing through reception of light in an ultraviolet (UV) wavelength range and converts an UV signal to a digital signal according to an embodiment of the present disclosure will be described in detail with reference to the accompanying drawings.

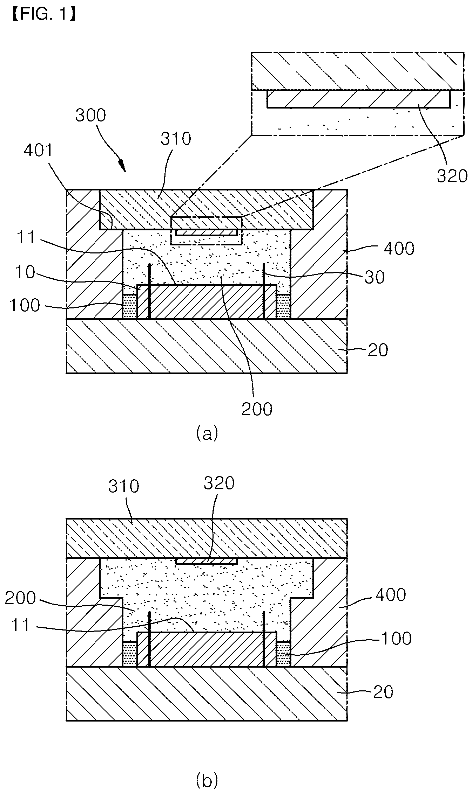

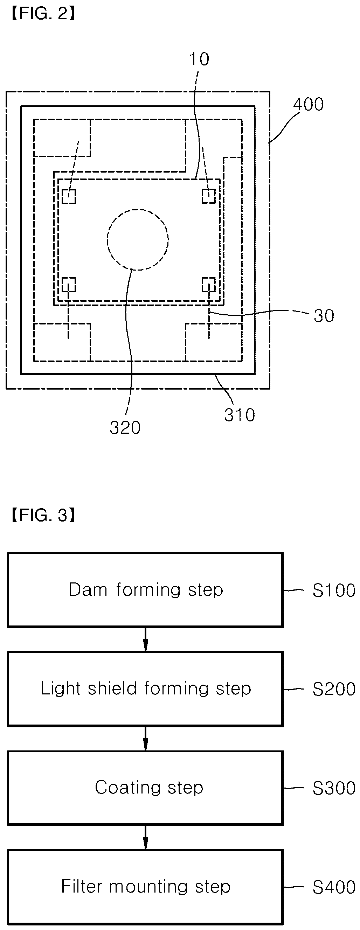

FIG. 1 is a cross-sectional view illustrating the package structure for the optical sensor that enables sensing through reception of light in the UV wavelength range and converts the UV signal to the digital signal according to an embodiment of the present disclosure, and FIG. 2 is a top view of an embodiment of the present disclosure.

As shown in FIGS. 1 and 2, the package structure for the optical sensor that enables sensing through reception of light in the UV wavelength range and converts the UV signal to the digital signal according to an embodiment of the present disclosure includes a light shield 100 and a light diffuser 200.

The light shield 100 is disposed in a printed circuit board (PCB) substrate on which a device portion for light sensing is mounted, and surrounds the device portion 10 such that a light receiving part 11 of the device portion 10 is exposed. The light shield 100 is made of a material that shields visible light, and blocks light coming in from the side of the device portion 10 except the light receiving part 11.

The light shield 100 is made of a material having visible light shielding property such as an opaque liquid resin, and is applied by the light diffuser disposed at the light receiving part such that it covers the light receiving part 11 of the device portion on the upper surface. The light shield 100 prevents visible light and moisture infiltration from the outer side of the device portion 10, thereby preventing a reduction in sensing sensitivity by the device portion and an error in light sensing. Here, the light sensed by the device portion refers to UV light.

As shown in FIG. 1, the light diffuser 200 may be stacked on the light receiving part 11 of the device portion 10 that receives UV light, be configured to cause UV light to penetrate and diffuse, and be made of a material including silicon dioxide (SiO₂) that allows light including UV light to pass through. When light including UV light enters, the light diffuser 200 may diffuse the light and allow it to pass through the light receiving part, thereby reducing the measurement deviation with the incident angle of UV light incident on the optical sensor, and minimizing a change in sensing sensitivity with a change in incident angle.

The light diffuser 200 may be made of an epoxy-based resin or a silicone-based resin to cause UV light to penetrate and diffuse, and may be formed of various types of materials that allow light to pass through, for example, a liquid resin for an optical waveguide, thereby preventing a reduction in absolute intensity of UV light incident on the light receiving part.

The above-described package structure for the optical sensor that enables sensing through reception of light in the UV wavelength range and converts the UV signal to the digital signal according to an embodiment of the present disclosure includes the light shield 100 surrounding the side of the device portion mounted on the PCB substrate to prevent light and moisture infiltration from the side of the device portion 10, and the light diffuser 200 disposed at the light receiving part 11 of the device portion 10 and made of a material that allows UV light to pass through, to cause UV light incident on the light receiving part to penetrate and diffuse, thereby reducing the measurement deviation with the incident angle of UV light incident on the optical sensor, minimizing a change in sensing sensitivity with a change in incident angle, preventing a reduction in absolute intensity of light incident on the optical sensor, and blocking ambient light and moisture coming in from outside.

Meanwhile, this embodiment preferably further includes a filter unit 300 and a package dam portion 400.

As shown in FIG. 1, the filter unit 300 may be configured to allow light of a specific wavelength to pass through and adjust the intensity of direct light, and may include a filter portion 310 and a pad portion 320. The filter portion 310 of the filter unit 300 is made of a material that allows light of the specific wavelength, i.e., UV light to pass through, and is stacked on the upper surface of the light diffuser 200 to allow only UV light to enter the light diffuser 200.

The filter portion 310 is connected to the pad portion 320, and the pad portion 320 is disposed at an area of contact with the light diffuser 200. Additionally, the filter portion 310 allows only UV light to enter the light receiving part 11 of the device portion and the UV light to be scattered off the light diffuser 200. Here, the light of the specific wavelength transmitted to the light diffuser 200 by the filter portion 310 may differ depending on the type of the filter portion.

The pad portion 320 of the filter unit 300 is disposed at the filter portion 310, and located facing the light receiving part of the device portion 10, to relatively reduce the intensity of direct light incident on the light receiving part, thereby minimizing the measurement deviation of the optical sensor, minimizing a change in sensing sensitivity, and preventing an error during the operation of the sensor. The pad portion 320 may be made of various types of light shielding materials, and may be made of a plated material to reduce the light intensity.

The pad portion 320 may be disposed facing the central area of the light receiving part 11 at the location facing the device portion 100, and formed with a smaller area than the area of the light receiving part, thereby reducing the intensity of direct light and maintaining sensing sensitivity.

The package dam portion 400 may be disposed between the filter portion 310 of the filter unit 300 and the PCB substrate 20, configured to surround the side of the light shield 100 and the light diffuser 200, and block light coming in from the side of the light diffuser 200, thereby ensuring the structural stability of the optical sensor, increasing reliability in sensing, and preventing sensing sensitivity and error caused by ambient light and moisture.

The package dam portion 400 may be configured to support the filter portion 310 so that the filter portion 310 is disposed at an upper end (see FIG. 1(B)), or may have an interference fit hole 401 at the upper end so that the filter portion 310 is inserted into the interference fit hole (see FIG. 1(A)).

The light shield 100 employed in this embodiment surrounds the side of the device portion 10 except the light receiving part 11 as described above, wherein the height of the light shield 100 from the PCB substrate is preferably lower than the height from the PCB substrate 20 to the upper surface of the device portion, and the light shield 100 allows only UV light having passed through the filter portion 310 and then scattered by the light diffuser 200 to smoothly enter the light receiving part 11 of the device portion.

The package structure for the optical sensor that enables sensing through reception of light in the UV wavelength range and converts the UV signal to the digital signal according to an embodiment of the present disclosure has been hereinabove described. Hereinafter, a method for manufacturing the package structure for the optical sensor that enables sensing through reception of light in the UV wavelength range and converts the UV signal to the digital signal according to an embodiment of the present disclosure will be described.

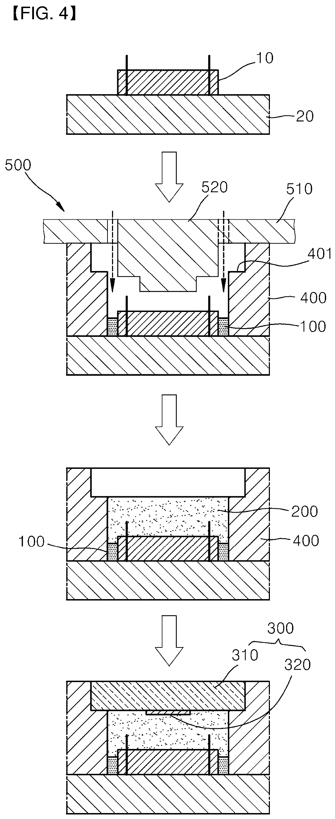

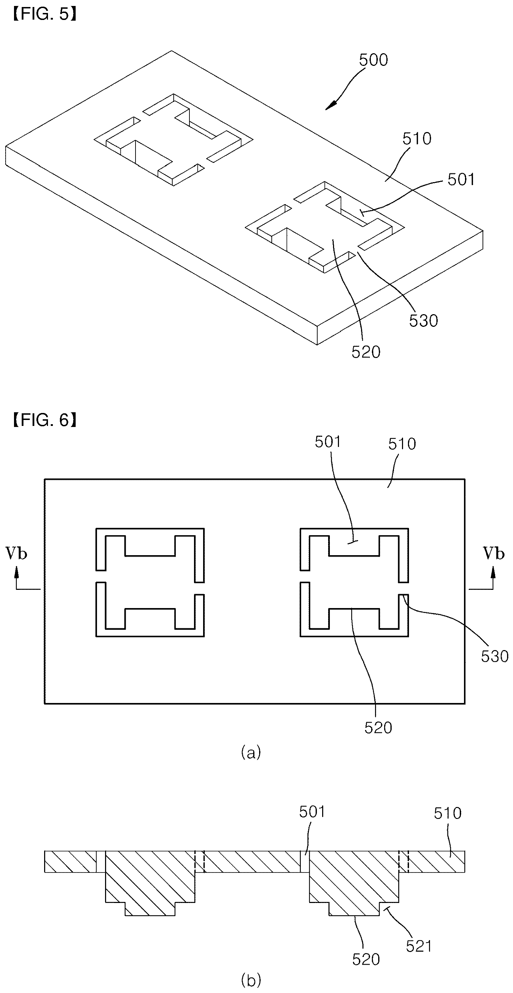

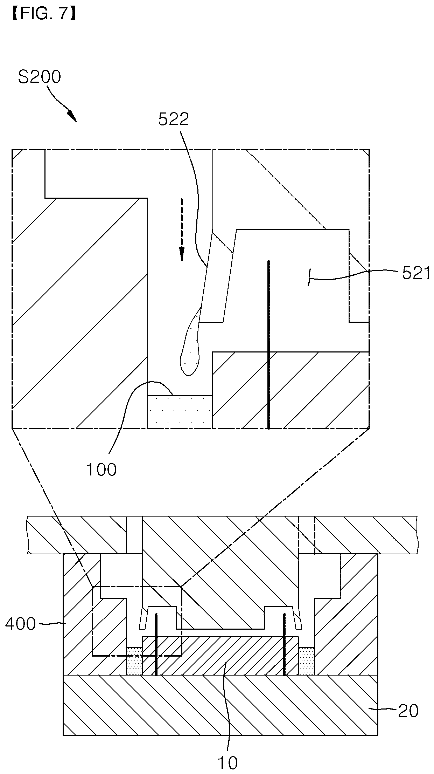

FIG. 3 is a block diagram illustrating the method for manufacturing the package structure for the optical sensor that enables sensing through reception of light in the UV wavelength range and converts the UV signal to the digital signal according to an embodiment of the present disclosure, FIG. 4 is a conceptual view illustrating a manufacturing method of an embodiment of the present disclosure, FIGS. 5 and 6 are diagrams illustrating a mask unit for forming the light shield in the manufacturing method of an embodiment of the present disclosure, and FIG. 7 is a diagram illustrating an extension rib employed in the mask unit used to form the light shield in the manufacturing method of an embodiment of the present disclosure.

As shown in FIG. 3, the method for manufacturing the package structure for the optical sensor that enables sensing through reception of light in the UV wavelength range and converts the UV signal to the digital signal according to an embodiment of the present disclosure includes a dam forming step (S100), a light shield forming step (S200), a coating step (S300) and a filter mounting step (S400).

In the dam forming step (S100), the package dam portion 400 may be formed using a mold process by a mold unit. In the dam forming step (S100), the package dam portion 400 is formed at the edge of the PCB substrate 20 on which the device portion 10 for light sensing is mounted by the mold process, to form a placement space having an open side for placing the device portion 10 on the PCB substrate. In the dam forming step (S100), the package dam portion 400 is formed using epoxy resin. Here, a circuit pattern electrically connected to the device portion and formed on the PCB substrate is disposed at the placement space together with the device portion.

In the light shield forming step (S200), the mask unit 500 is mounted on the package dam portion 400 such that it covers the placement space, and a light shielding material is fed into the placement space through an inlet slit 501 formed in the mask unit 500 to form the light shield 100 surrounding the side of the device portion.

As shown in FIG. 4, in the light shield forming step (S200), the light shielding material is fed into the filling space to form the light shield 100 with the height from the PCB substrate 20 that is lower than the height to the upper surface of the device portion by using the mask unit 500, to prevent the light shield 100 from intruding an electrical wire connecting the upper surface of the device portion 10 to the circuit pattern. Additionally, the light shield forming step (S200) may further include a curing step of curing the light shield through a curing machine at a preset temperature for a preset time so that the light shield 100 made of the light shielding material may be stably disposed on the PCB substrate, surrounding the side of the device portion.

In the coating step (S300), the mask unit 500 is separated from the package dam portion 400, and a light permeable material is fed into the placement space to stack the light diffuser 200 on the light receiving part 11 of the device portion 10. In the coating step (S300), the light permeable material may be fed into the placement space to form the light diffuser 200 with a height that is equal to or lower than the height of the package dam portion 400, to cause UV light to be scattered while it passes through the light diffuser and penetrate the light receiving part of the device portion. The light permeable material fed into the placement space in the coating step (S300) may include a liquid resin for an optical waveguide, and the coating step (S300) may further include a resin curing step of curing the liquid resin for the optical waveguide fed into the placement space to form the light diffuser.

In the filter mounting step (S400), the filter unit 300 that allows light of the specific wavelength to pass through and reduces the intensity of direct light incident on the light receiving part is installed at the package dam portion 400 such that the filter portion 310 is stacked on the light diffuser, to allow the device portion to receive and sense only UV light scattered by the light diffuser after it has passed through the filter portion.

Meanwhile, as shown in FIGS. 5 and 6, the mask unit 500 for forming the light shield in the light shield forming step (S200) preferably includes a base plate portion 510, a cover portion 520 and a connection rib 530. The base plate portion 510 is mounted on the package dam portion 400 by a device for towing, and has a through-hole through which the light shielding material is fed into the placement space in which the light shield is formed.

The cover portion 520 is formed with a width corresponding to the light receiving part 11 of the device portion and disposed at the through-hole of the base plate portion 510 to form the inlet slit 501 between the cover portion 520 and the base plate portion 510, and protruded toward the light receiving part 11 to cover the light receiving part 11, so that the light shielding material is fed into the placement space such that it surrounds the outer side of the device portion 10 via the inlet slit 501 and the light shield is not applied to the light receiving part 11.

The connection rib 530 connects the base plate portion 510 to the cover portion 520 and maintains the shape of the inlet slit 501 through which the light shielding material is fed into the placement space, to smoothly feed the light shielding material into the placement space and stably fix the position of the cover portion 520 above the device portion 10.

Meanwhile, the cover portion 520 may have a cover groove 521 to prevent the exposure of the electrical wire 30 so as to prevent the electrical wire from being coated by the light shielding material being fed. The cover groove 521 is preferably disposed at a location facing the electrical wire and formed in the shape of a groove.

As shown in FIG. 7, the cover portion 520 may have the extension rib 522 extended toward the PCB substrate 20 to limit the cover groove together with forming the cover groove. The extension rib 522 is disposed at the outer side of the cover portion, to prevent the electrical wire inserted into the cover groove 521 from being exposed to the placement space. The extension rib 522 may be formed at an angle toward the inner side of the package dam portion, so when the light shielding material is fed into the placement space to form the light shield, the light shielding material is not applied to the electrical wire and is only guided to the side of the device portion.

Each of the dam forming step (S100), the light shield forming step (S200), the coating step (S300) and the filter mounting step (S400) may be performed by the mold unit, the towing device, the device for liquid material injection and the molding device, and may be performed by a controller (not shown) in which a program for the operation of each device is stored. Additionally, the controller may include a computer or a dedicated terminal in which the program may be stored.

While various embodiments of the present disclosure have been hereinabove described, these embodiments and the accompanying drawings are provided to clearly describe some of the technical spirit included in the present disclosure, and it is obvious that the scope of protection of the present disclosure covers all variations and specific embodiments that can be easily inferred by those skilled in the art within the technical spirit and scope included in the specification and drawings.

## Claims

1. A package structure for an optical sensor that enables sensing through reception of light in an ultraviolet (UV) wavelength range and converts an UV signal to a digital signal, comprising:
a light shield disposed at a printed circuit board (PCB) substrate on which a device portion for light sensing is mounted, surrounding the device portion such that a light receiving part of the device portion is exposed, and made of a material that blocks visible light coming in from a side of the device portion except the light receiving part; and
a light diffuser disposed at the light receiving part of the device portion, configured to allow the light to pass through and diffuse the light, and made of a material including silicon dioxide.

2. The package structure for the optical sensor that enables sensing through reception of light in the UV wavelength range and converts the UV signal to the digital signal according to claim 1, further comprising:
a filter unit including a filter portion stacked on the light diffuser and made of a material that allows light of a specific wavelength to pass through, and a pad portion disposed at the filter portion and located facing the light receiving part of the device portion to relatively reduce an intensity of direct light incident on the light receiving part.

3. The package structure for the optical sensor that enables sensing through reception of light in the UV wavelength range and converts the UV signal to the digital signal according to claim 2, wherein the pad portion of the filter unit faces a central area of the light receiving part, and is formed with a narrower area than an area of the light receiving part, and made of a light shielding material.

4. The package structure for the optical sensor that enables sensing through reception of light in the UV wavelength range and converts the UV signal to the digital signal according to claim 2, further comprising:
a package dam portion disposed between the filter portion of the filter unit and the PCB substrate, and surrounding a side of the light shield and the light diffuser to block light coming in from the side of the light diffuser.

5. A method for manufacturing a package structure for an optical sensor that enables sensing through reception of light in an ultraviolet (UV) wavelength range and converts an UV signal to a digital signal, the method comprising:
a dam forming step of forming, by a mold unit, a package dam portion at an edge of a printed circuit board (PCB) substrate on which a device portion for light sensing is mounted by a mold process, to form a placement space having an open side to place the device portion on the PCB substrate;
a light shield forming step of mounting a mask unit on the package dam portion such that the mask unit covers the placement space, and feeding a light shielding material into the placement space through an inlet slit formed in the mask unit to form a light shield surrounding a side of the device portion;
a coating step of separating the mask unit from the package dam portion, and feeding a light permeable material into the placement space to stack a light diffuser on the light receiving part of the device portion; and
a filter mounting step of installing a filter unit at the package dam portion such that a filter portion is stacked on the light diffuser, to allow light of a specific wavelength to pass through and reduce an intensity of direct light incident on the light receiving part.
